(19) **Europäisches Patentamt / European Patent Office / Office européen des brevets**

(11) **EP 1 444 779 B1**

(12) # FASCICULE DE BREVET EUROPEEN

(45) Date de publication et mention de la délivrance du brevet:
**04.05.2011 Bulletin 2011/18**

(21) Numéro de dépôt: **02788056.6**

(22) Date de dépôt: **14.11.2002**

(51) Int Cl.:
***H03H 9/02*** (2006.01)

(86) Numéro de dépôt international:
**PCT/FR2002/003902**

(87) Numéro de publication internationale:
**WO 2003/043189 (22.05.2003 Gazette 2003/21)**

(54) **RESONATEUR MICRO-ELECTRO-MECANIQUE A ENTREFER LATERAL AJUSTABLE ET PROCEDE DE REGLAGE DU MEME**

MIKROELEKTROMECHANISCHER RESONATOR MIT ABSTIMMBAREM LUFTSPALT UND VERFAHREN ZU DESSEN ABSTIMMUNG

METHOD FOR GAP ADJUSTMENT OF TWO MECHANICAL ELEMENTS OF A SUBSTANTIALLY PLANAR MICRO-MECHANICAL STRUCTURE AND CORRESPONDING ELECTROMECHANICAL RESONATOR

(84) Etats contractants désignés:
**CH DE FI FR GB LI SE**

(30) Priorité: **15.11.2001 FR 0114798**

(43) Date de publication de la demande:
**11.08.2004 Bulletin 2004/33**

(73) Titulaire: **CENTRE NATIONAL DE LA RECHERCHE SCIENTIFIQUE (CNRS) 75016 Paris (FR)**

(72) Inventeurs:
• **KAISER, Andreas**
  **F-59650 Villeneuve d'Ascq (FR)**
• **GALAYKO, Dimitri, Yurievitch**
  **F-59800 Lille (FR)**
• **COLLARD, Dominique, Jules, Victor**
  **F-59130 Lambersart (FR)**

(74) Mandataire: **Fréchède, Michel et al Cabinet Lavoix 2 place d'Estienne d'Orves 75441 Paris Cedex 09 (FR)**

(56) Documents cités:
**US-B1- 6 236 281**

• **HIRANO T ET AL: "Operation of sub-micron gap electrostatic comb-drive actuators" TRANSDUCERS. SAN FRANCISCO, JUNE 24 - 27, 1991, PROCEEDINGS OF THE INTERNATIONAL CONFERENCE ON SOLID STATE SENSORS AND ACTUATORS, NEW YORK, IEEE, US, vol. CONF. 6, 24 juin 1991 (1991-06-24), pages 873-876, XP010037297 ISBN: 0-87942-585-7**
• **TOSHIKI HIRANO ET AL: "DESIGN, FABRICATION, AND OPERATION OF SUBMICRON GAP COMB-DRIVE MICROACTUATORS" JOURNAL OF MICROELECTROMECHANICAL SYSTEMS, IEEE INC. NEW YORK, US, vol. 1, no. 1, 1 mars 1992 (1992-03-01), pages 52-59, XP000304102 ISSN: 1057-7157**
• **WAN-THAI HSU ET AL: "A sub-micron capacitive gap process for multiple-metal-electrode lateral micromechanical resonators" PROCEEDINGS OF THE IEEE 14TH. ANNUAL INTERNATIONAL CONFERENCE ON MICROELECTRO MECHANICAL SYSTEMS. MEMS 2001. INTERLAKEN, SWITZERLAND, JAN. 21 - 25, 2001, IEEE INTERNATIONAL MICRO ELECTRO MECHANICAL SYSTEMS CONFERENCE, NEW YORK, NY: IEEE, US, vol. CONF. 14, 21 janvier 2001 (2001-01-21), pages 349-352, XP010534622 ISBN: 0-7803-5998-4**

**Description**

L'invention concerne un procédé de réglage de l'écartement de deux éléments mécaniques d'une structure micromécanique sensiblement plane et un résonateur électromécanique correspondant.

Dans le domaine de la technologie des microsystèmes, de nombreuses applications nécessitent la mise en oeuvre de couches structurelles dites couches épaisses, dont l'épaisseur est comprise entre 10 $\mu$m et 30 $\mu$m. De telles épaisseurs, relativement importantes, permettent de constituer, dans les structures micromécaniques incorporant celles-ci, des éléments mécaniques d'ancrage d'éléments mécaniques d'inertie beaucoup plus faible et destinés à jouer le rôle d'éléments mobiles ajustables.

En contre-partie, une augmentation des épaisseurs des couches, pour former de tels éléments mécaniques d'ancrage, se traduit systématiquement par une augmentation des dimensions planaires minimales réalisables des éléments précités, et, en conséquence, des intervalles de séparation latéraux entre ces éléments. On rappelle, en effet, que tous les processus de micro-gravure actuellement disponibles dans le domaine technique considéré sont dits à facteur de forme constant, le facteur de forme étant habituellement défini comme le rapport entre les dimensions latérales ou planaires minimales et l'épaisseur, dans la direction perpendiculaire aux dimensions précitées, de ces microstructures.

De telles microstructures sont habituellement utilisées dans le domaine des circuits radiofréquences, dans la bande de fréquences comprises entre 10 MHz et 100 MHz.

Afin d'assurer un accord en fréquence radioélectrique dans l'ensemble du domaine de la bande de fréquences précitée, et ce avec une finesse d'accord la meilleure, par ajustement des dimensions planaires de ces éléments et des intervalles de séparation de ces derniers, les intervalles de séparation précités doivent pouvoir atteindre les valeurs les plus faibles, en particulier valeurs d'intervalles de séparation très en deçà de la résolution habituelle des processus de microgravure mis en oeuvre.

Parmi les structures micromécaniques constituées de résonateurs micromécaniques connues, on peut citer celle décrite dans la publication intitulée "VHF Free-Free Beam High-Q Micro-mechanical Resonators" publiée par Kun Wang, Yinglei Yu, Ark-Chew Woung et Clara T.-C. Nguyen, Technical Digest, 12th International IEEE Micro Electro Mechanical Systems Conference, Orlando, Florida, Jan 17-21-1999, pp 453-458.

Le résonateur précité est suspendu sur des poutres flexibles et attiré électrostatiquement par une électrode enterrée, dans une direction orthogonale à la dimension planaire du substrat.

La technique décrite permet de réduire l'entrefer du résonateur de 1,5 $\mu$m à 0,3 $\mu$m.

Elle est toutefois limitée aux résonateurs excités verticalement, dans la direction orthogonale à la dimension planaire du substrat, au moyen d'une électrode enterrée, ce qui limite son application aux technologies à couches minces.

La transposition d'une telle technique aux couches épaisses nécessite des niveaux de tension trop importants pour être exploitable industriellement.

De plus une telle technique nécessite plusieurs niveaux de masquage, des procédés multicouches et des opérations de micro-usinage assez complexes et qui, pour cette raison, peuvent être difficilement appliquées dans un processus industriel.

Enfin la technique précitée limite considérablement la liberté de conception des structures et ne permet donc pas d'exploiter des modes de vibration radiofréquences complexes, lesquels sont très utiles dans les résonateurs et/ou capteurs radiofréquences.

La publication intitulée "Operation of sub-micron gap electrostatic comb-drive actuators" publiée par T. Hirano; T. Furuhata; K.J. Gabriel et H. Fujita, International Conference on Solid-State Sensors and Actuators, 24-27 June 1991, San Francisco, CA, USA, pp 873 - 876, décrit un procédé pour ajuster l'écartement entre deux éléments mécaniques, qui se déplacent, l'une par rapport à l'autre, dans la direction parallele au substrat.

La mise en oeuvre de structures micromécaniques à couches épaisses et leur application à la réalisation de résonateurs électromécaniques conformément aux techniques de l'art antérieur s'avère donc, très délicate, la mise en oeuvre de structures évolutives ne pouvant en outre, pour cette raison, être envisagée.

La présente invention a pour objet de remédier aux inconvénients et limitation des techniques de l'art antérieur, par la mise en oeuvre d'un procédé de réglage de l'écartement de deux éléments mécaniques d'une structure micromécanique sensiblement plane permettant d'ajuster les valeurs d'intervalles de séparation d'éléments de structure micromécanique à des valeurs de dimension très inférieure à la résolution du processus de microgravure utilisé pour la réalisation de telles structures micromécaniques.

Un autre objet de la présente invention est la mise en oeuvre d'un procédé de réglage de l'écartement de deux éléments mécaniques d'une structure micromécanique sensiblement plane réalisée en technologie de couches minces ou de couches épaisses ou grâce à tout type de technologie, en raison de la structure sensiblement plane de la structure mécanique précitée.

Un autre objet de la présente invention est également la mise en oeuvre d'un circuit résonateur électromécanique de configuration sensiblement plane présentant, pour cette raison, une très grande fiabilité et une grande dynamique de réglage d'accord en fréquence radioélectrique.

Un autre objet de la présente invention est également la mise en oeuvre d'un circuit résonateur électromécanique, dont la fréquence radioélectrique de résonance peut être ajustée avec une grande précision par application d'une tension électrique de commande de valeur réduite.

Le procédé de réglage de l'écartement de fonctionnement de deux éléments mécaniques d'une structure mécanique sensiblement plane obtenue par un processus de micro-gravure, objet de la présente invention s'applique à des éléments mécaniques formés par un élément et par un autre élément de cette structure comprenant chacun une face, ou bord, sensiblement plane en vis à vis et présentant un écartement résiduel sensiblement égal à la résolution du processus de micro-gravure.

Il est remarquable en ce qu'il consiste au moins à attribuer à l'un des éléments une position fixe de référence dans la structure et à rendre libre, selon au moins un degré de liberté dans la direction de l'écartement résiduel l'autre élément par rapport à cet élément.

Il consiste en outre à relier cet autre élément à la position fixe de référence par une liaison élastique, cet autre élément en présence de cette liaison élastique occupant une position de repos pour la quelle l'écartement entre chaque face sensiblement plane en vis à vis est sensiblement égal à l'écartement résiduel. Il consiste ensuite à installer, entre l'élément constituant la position fixe de référence dans la structure et l'autre élément rendu libre, au moins une cale de butée, de façon à ménager entre l'autre élément et cette cale de butée un écartement de butée définissant l'amplitude maximale de déplacement de cet autre élément entre la position de repos et une position de butée constituant position de fonctionnement.

L'autre élément est alors soumis à un déplacement antagoniste à la liaison élastique jusqu'à la position de butée constituant position de fonctionnement, l'écartement résiduel étant ainsi réduit à un écartement de fonctionnement égal à la différence entre cet écartement résiduel et l'écartement de butée et inférieur à la résolution du processus de micro-gravure.

Le circuit résonateur électromécanique à entrefer latéral ajustable, objet de la présente invention, est remarquable en ce qu'il comprend au moins, formés par un processus de micro-gravure sur un substrat diélectrique et agencés selon une structure sensiblement plane, un élément résonateur électriquement conducteur ancré dans une structure présentant une position fixe de référence, un autre élément constituant électrode de signal, l'élément résonateur et l'autre élément présentant chacun une face sensiblement plane en vis à vis séparées par un écartement résiduel sensiblement égal à la résolution du processus de micro-gravure. Cet autre élément présente un degré de liberté dans la direction de l'écartement résiduel. Un élément d'ancrage de cet autre élément constituant électrode de signal est prévu et au moins une liaison élastique relie cet autre élément constituant électrode de signal et cet élément d'ancrage. L'autre élément constituant électrode de signal en présence de la liaison élastique occupe une position de repos pour laquelle l'écartement entre chaque face sensiblement plane en vis à vis est sensiblement égal à l'écartement résiduel. Une cale de butée est en outre installée entre la structure présentant une position fixe de référence et cet autre élément, constituant électrode de signal, de façon à ménager entre cet autre élément et la cale de butée un écartement de butée, définissant l'amplitude maximale de déplacement de cet autre élément entre la position de repos et une position de butée, constituant position de fonctionnement. Des circuits d'application, entre cet autre élément constituant électrode de signal et une électrode fixe vis à vis de l'élément constituant résonateur, d'une différence de potentiel électrique permettent de constituer un moteur électrostatique à entrefer ajustable en fonction de la différence de potentiel appliquée, moteur électrostatique formé par l'élément résonateur ou une électrode auxiliaire, l'autre élément constituant électrode de signal et la liaison élastique. Le moteur électrostatique permet de réduire l'écartement résiduel à un écartement de fonctionnement égal à la différence entre cet écartement résiduel et l'écartement de butée et inférieur à la résolution du processus de microgravure.

Le procédé et le circuit résonateur objets de l'invention trouvent application à la fabrication de filtres ou résonateurs électromécaniques pour engendrer ou discriminer des signaux radiofréquences dans des bandes de fréquences comprises entre 10 MHz et 100 MHz par exemple.

Ils seront mieux compris à la lecture de la description et à l'observation des dessins ci-après dans lesquels:

- la figure 1 représente, à titre purement illustratif, un schéma synoptique des étapes de mise en oeuvre du procédé objet de la présente invention ;
- les figures 2a et 2b représentent, selon une vue de dessus, un circuit résonateur électromécanique en position de repos, aucune différence de potentiel électrique n'étant appliquée entre l'élément constituant résonateur et l'autre élément constituant électrode de signal, cet autre élément se trouvant, en conséquence, en position de repos, respectivement ce même circuit résonateur électromécanique lorsqu'une différence de potentiel électrique est appliquée pour amener cette autre électrode en position de butée et de fonctionnement ;
- la figure 3 représente un mode de mise en ouvre spécifique d'un résonateur, comportant deux circuits résonateurs en tête-bêche, tels que représentés en figure 2a et 2b ;
- la figure 4a représente une caractéristique de transmission, atténuation, en fonction de la fréquence pour un premier et un deuxième circuit résonateur spécifiques constitutifs d'un résonateur, tel que représenté en figure 3 ;

- la figure 4b représente une caractéristique d'accord en fréquence en fonction de la différence de potentiel électrique, ou tension de polarisation, appliquée entre l'élément résonateur et l'autre élément constitutif de l'électrode de signal pour un premier et un deuxième circuit résonateur spécifiques constitutifs d'un résonateur, tel que représenté en figure 3.

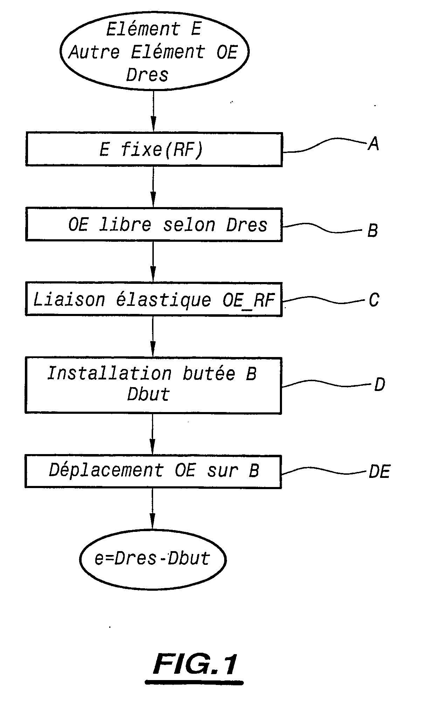

Une description plus détaillée du procédé de réglage de l'écartement de fonctionnement entre deux éléments mécaniques d'une structure mécanique ou micro mécanique sensiblement plane obtenue par un processus de micro-gravure conforme à l'objet de la présente invention sera maintenant donnée en liaison avec la figure 1.

D'une manière générale, en référence à la figure précitée, on considère une structure micromécanique, tel qu'un résonateur électromécanique par exemple, formé sur une structure micromécanique sensiblement plane et obtenue par micro-gravure.

Les éléments mécaniques de la structure micromécanique sont formés par un élément E et par un autre élément OE chaque élément comprenant par exemple une face, ou bord, sensiblement plane, chacune des faces précitées étant en vis à vis et présentant un écartement résiduel obtenu grâce au processus de gravure ou de micro-gravure utilisé. Cet écartement résiduel est sensiblement égal à la résolution du processus de micro-gravure pour cette raison.

Lorsque la structure micromécanique est celle d'un résonateur électromécanique, on comprend en particulier que l'écartement résiduel précité est la valeur limite de l'entrefer du résonateur micromécanique, cet écartement correspondant donc à une limite inférieure de la valeur d'écartement et de la valeur d'entrefer finalement obtenue par la seule mise en oeuvre du processus de microgravure.

Dans ces conditions, le procédé, objet de l'invention, de réglage de l'écartement de fonctionnement de deux éléments mécaniques, tel que l'élément E, et l'autre élément, OE, consiste à partir de leur position respective et de l'écartement résiduel Dres séparant ces derniers, à attribuer à une étape A à l'un des éléments, l'élément E par exemple, une position fixe dite de référence RF dans la structure micromécanique précitée.

L'étape A est suivie d'une étape B consistant à rendre libre selon au moins un degré de liberté, dans la direction de l'écartement résiduel Dres précité, l'autre élément OE par rapport à l'élément E et bien entendu par rapport à la position fixe de référence de ce dernier.

L'étape B est suivie d'une étape C consistant à relier l'autre élément OE, rendu libre, à la position fixe de référence RF par une liaison élastique S. L'autre élément OE, en présence de la liaison et la liaison élastique S occupe une position de repos pour laquelle l'écartement entre chaque face sensiblement plane en vis à vis est sensiblement égal à l'écartement résiduel Dres.

L'étape C peut alors être suivie d'une étape D consistant à installer entre l'élément E, constituant la position fixe de référence RF, et l'autre élément rendu libre, OE, au moins une cale de butée B de façon à ménager, entre l'autre élément OE et la cale de butée B, un écartement de butée Dbut. L'écartement de butée est choisi de façon à présenter une valeur déterminée permettant de définir l'amplitude maximale de déplacement de l'autre élément, OE, entre la position de repos et la position de butée constituant position de fonctionnement.

L'étape D est alors suivie d'une étape DE consistant à soumettre l'autre élément OE à un déplacement antagoniste à la liaison élastique S jusqu'à la position de butée constituant position de fonctionnement. Ceci permet de réduire l'écartement résiduel à un écartement de fonctionnement e égal à la différence entre l'écart résiduel et l'écartement de butée et inférieur à la résolution du processus du microgravure.

L'écartement de fonctionnement entre l'élément E et l'autre élément OE vérifie alors la relation :

$$e = Dres-Dbut$$

Le procédé objet de la présente invention peut avantageusement être mis en oeuvre pour le réglage de l'écartement de fonctionnement d'un résonateur électromécanique et en particulier de l'entrefer de ce dernier.

Dans ces conditions, l'élément E et l'autre élément OE sont constitués en un matériau électriquement conducteur obtenu par exemple par micro-gravure d'un substrat de poly-silicium, rapporté sur un substrat d'électrique par exemple, conformément à la technique de micro-gravure des circuits intégrés.

Dans ces conditions, l'étape consistant à soumettre l'autre élément, OE, à un déplacement antagoniste à la liaison élastique S tel que représentée à l'étape E de la figure 1 peut avantageusement consister à appliquer entre l'autre élément OE et une électrode fixe FE liée à l'élément E, en particulier à la position fixe de référence RF, une différence de potentiel électrique spécifique. Dans ces conditions, l'ensemble formé par l'électrode fixe liée à l'élément E, l'autre élément OE et la liaison élastique S et la différence de potentiel électrique appliquée constituent un moteur électrostatique à entrefer ajustable.

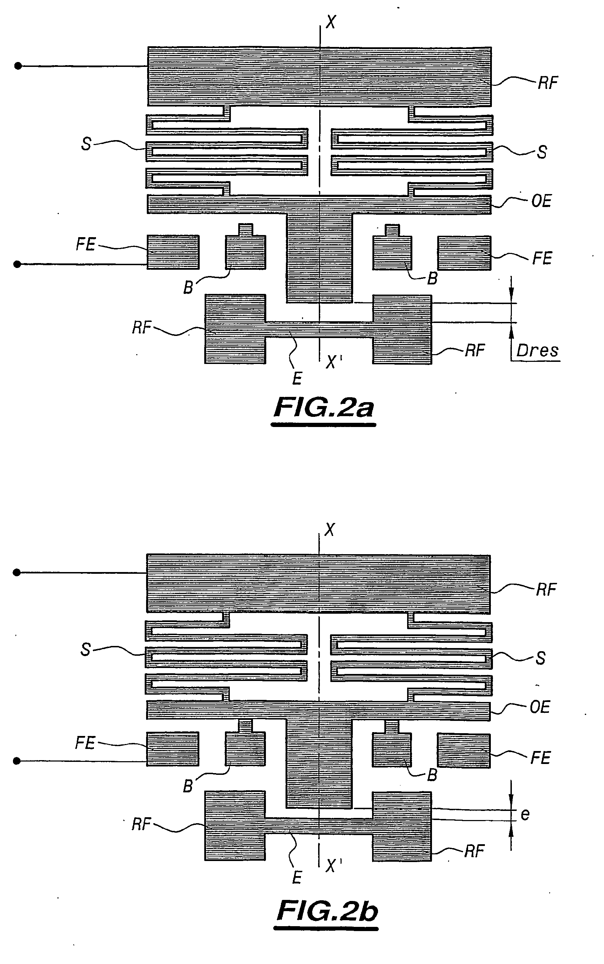

La mise en ouvre du procédé objet de la présente invention dans ces conditions, est représenté en figure 2a respectivement 2b.

Sur la figure 2a on a représenté l'ensemble des éléments en vue de dessus, les éléments en matériau poly-silicium électriquement conducteur étant représentés en grisé dans le plan de la figure et étant constitué par des bandes de matériau poly-silicium rapporté sur un substrat d'électrique non représenté au dessin.

On constate, en particulier, que l'ancrage de l'élément E constituant un résonateur est effectué par rapport à des masses mécaniques RF assurant la position fixe précitée et que l'autre élément OE constituant l'électrode de signal, est en fait subdivisé en une partie mobile OE et une partie fixe assurant la position fixe de référence RF, l'autre élément OE, constituant électrode de signal et la partie d'ancrage constituant la position fixe de référence RF étant mécaniquement reliés par la liaison élastique constituée par deux éléments en méandre S sur les figures 2a et 2b.

Sur la figure 2a la différence de potentiel électrique appliquée entre l'électrode fixe FE et l'élément d'ancrage assurant la position fixe de référence RF de l'autre élément OE constituant l'électrode de signal est sensiblement nulle. Dans ces conditions, l'écart entre l'élément E et l'autre élément OE constituant électrode de signal correspond à l'écartement résiduel Dres.

Sur la figure 2b au contraire lors de l'application d'une différence de potentiel V différente de 0, supérieure à 0 par exemple, le moteur électrostatique ainsi constitué permet de déplacer l'autre élément, OE, constituant électrode de signal rendu mobile vers l'élément, E, et de réduire ainsi la valeur de l'écartement à l'écartement de fonctionnement e dans les conditions précédemment mentionnées dans la description.

La position finale correspond à la position de butée sur les cales de butée B placée par exemple au voisinage de l'électrode fixe FE.

Le procédé objet de la présente invention apparaîtrait particulièrement avantageux lorsque la structure micromécanique constituant la structure d'un résonateur électromécanique, et, en particulier, l'élément constituant l'élément résonateur E, l'autre élément OE, constituant l'électrode de signal, et la liaison élastique sont formés par des structures électriquement conductrices sensiblement planes sur un substrat d'électrique.

Dans ces conditions, la fréquence de résonance mécanique de l'élément E, constituant résonateur, représente la fréquence de fonctionnement du signal du résonateur en mode de vibration latérale.

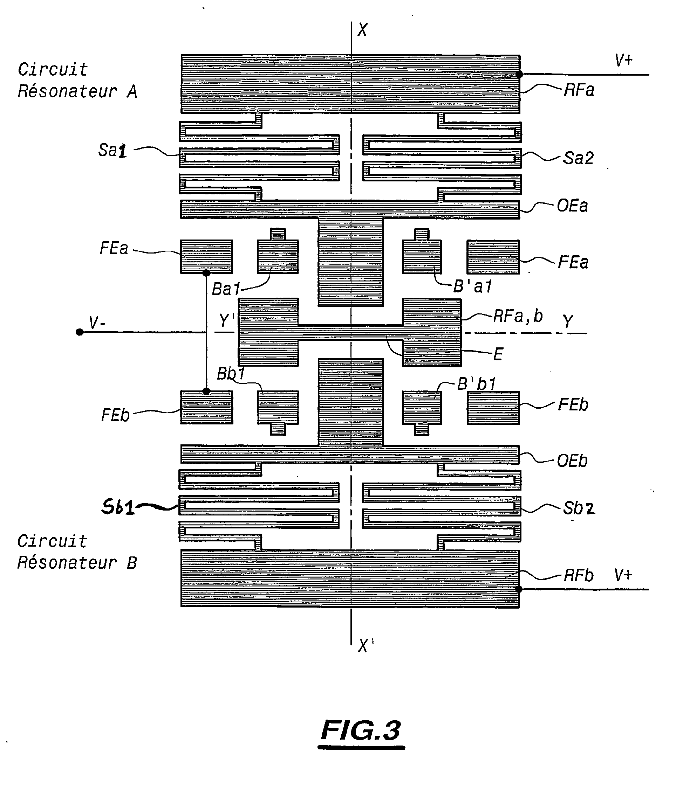

Une description plus détaillée d'un circuit résonateur et d'un résonateur électromécanique, conforme à l'objet de la présente invention sera maintenant donnée en liaison avec les figures 2a et 2b et la figure 3.

D'une manière générale, on indique que le circuit résonateur et le résonateur électromécanique à entrefer latéral ajustable, conformes à l'objet de la présente invention, comprennent des éléments mécaniques électriquement conducteurs formé par un processus de micro-gravure sur un substrat d'électrique, ces éléments étant agencés selon une structure sensiblement plane.

L'élément E constitue un élément résonateur électriquement conducteur et est ancré dans une structure représentant la position fixe de référence RF.

L'autre élément OE et l'élément E résonateur présentent une face ou un bord plan en vis à vis et sont séparés en position de repos, c'est-à-dire en l'absence d'application de déplacement de l'autre élément OE constituant l'électrode de signal, de l'écartement résiduel précédemment mentionné dans la description. L'autre élément OE est séparé, c'est-à-dire désolidarisé de la position fixe de référence RF, de façon à présenter un degré de liberté dans les directions de l'écartement résiduel précité. Il est toutefois relié par une liaison élastique, telle qu'un ressort S par exemple, formé par une structure à méandre de poly-silicium. La structure à méandres précitée peut être constituée par deux structures à méandres élémentaires disposées symétriquement par rapport à un axe longitudinal de symétrie X'X du circuit résonateur précité. Les structures à méandres relient l'autre élément OE, constituant l'électrode de signal, à l'élément d'ancrage constituant la position fixe de référence pour ce dernier.

En ce qui concerne les cales de butée B, celles-ci sont installées entre la structure présentant la position de référence et l'autre élément OE constituant un électrode de signal de façon à ménager, entre cet autre élément OE et la où les cales de butée B, un écartement de butée ainsi que mentionné précédemment dans la description. L'écartement de butée définit l'amplitude maximale de déplacement de l'autre élément OE, c'est-à-dire de l'électrode de signal, entre la position de repos et la position de butée constituant la position de fonctionnement.

Enfin, le circuit résonateur tel que représenté en figure 2a ou 2b comprend des circuits permettant d'appliquer la différence de potentiel, différence de potentiel continue entre l'autre élément, OE, et une électrode fixe, FE, mécaniquement solidaire de l'élément E par l'intermédiaire de la position fixe de référence RF pour constituer le moteur électrostatique, ainsi que mentionné précédemment dans la description.

Sur la figure 2a et la figure 2b on indique que les circuits d'application de la différence de potentiel sont représentés schématiquement par des lignes électriques connectées à l'électrode fixe FE respectivement à la partie d'ancrage assurant la position fixe de référence RF pour l'autre élément OE constituant l'électrode de signal.

En fonctionnement, on indique que l'électrode de signal constituée par l'autre élément OE n'est pas directement soumise à la tension de polarisation permettant d'appliquer la différence de potentiel précité mais par l'intermédiaire de la liaison élastique formée par les ressorts S. Sous l'action de champs électrostatiques ainsi crées entre les électrodes du moteur, électrode fixe FE et électrode de signal formée par l'autre élément OE, cette dernière se rapproche de l'électrode fixe FE et de l'élément E formant résonateur et se positionne en position de fonctionnement, c'est-à-dire sur les cales de butée B.

Dans ces conditions, l'entrefer de fonctionnement e vérifie la relation précédemment mentionnée dans la description, laquelle est constituée par la différence entre deux écartements engendrés par le processus de micro-gravure. Cet écartement de fonctionnement présente alors des valeurs bien inférieures aux écartements de micro-gravure qui sont les limites d'écartement inhérentes au processus de micro-gravure utilisé.

On indique que le procédé objet de la présente invention permet la mise en oeuvre de circuits résonateurs de manière industrielle en raison, notamment, de l'insensibilité du procédé objet de la présente invention au phénomène de surgravure de la couche structurelle. Lors du micro-usinage de la couche épaisse de silicium, les bords de structure ou microstructure sont consommés sur une largeur proche de 3 à 5% de l'épaisseur à graver, c'est-à-dire entre 0,6 $\mu$m et 1 $\mu$m de gravure latérale, pour une couche de 20 $\mu$m d'épaisseur. Ce phénomène de surgravure latérale provoque une réduction de dimension des éléments gravés et augmente la largeur de tous les écartements. La largeur de silicium consommée sur les bords est donc imprévisible car elle dépend des conditions des processus de microgravure mais reste constante sur des motifs voisins. Un tel phénomène de surgravure ne permet donc pas de prévoir un dimensionnement précis des structures et des écartements associés à ces dernières.

Au contraire, la mise en oeuvre du procédé, objet de la présente invention, permet de définir des résonateurs comportant des écartements de fonctionnement, c'est-à-dire d'entrefer de fonctionnement entre l'élément E constituant résonateur et l'autre élément OE constituant l'électrode de signal, lesquels sont déterminés par la différence entre les largeurs de deux écartements résiduels. Le phénomène de surgravure connu de l'art antérieur étant bien entendu présent et constant pour les deux écartements, l'effet de ce phénomène s'annule par différence et le phénomène de surgravure est donc supprimé sensiblement et n'apparaît pas sur la valeur finale de l'écartement de fonctionnement. Dans ces conditions, l'écartement final est uniquement défini par les masques de lithographie. On conçoit, en effet, que les masques de lithographie permettent de définir non seulement les déplacements précités mais également les épaisseurs de cales de butée lesquelles, bien entendu, déterminent la valeur de déplacement de l'électrode de signal constitué par l'autre élément OE.

La figure 3 représente un résonateur électromécanique réalisé grâce à la mise en oeuvre du procédé objet de la présente invention.

Alors que le circuit résonateur, tel que représenté en figure 2a et 2b, présente une structure sensiblement symétrique par rapport à un axe longitudinal X'X de symétrie sensiblement parallèle à l'écartement résiduel Dres, le résonateur électromécanique objet de la présente invention, tel que représenté en figure 3, comporte un premier circuit résonateur, désigné circuit résonateur A, et un deuxième circuit résonateur, désigné circuit résonateur B, tels que décrits précédemment dans la description en liaison avec des figures 2a et 2b.

Les circuits résonateurs A et B sont disposés en tête-bêche symétriquement par rapport à un axe Y'Y orthogonal à l'axe longitudinal de symétrie X'X.

Sur la figure 3, les mêmes références représentent les mêmes éléments que dans le cas des figures 2a et 2b, ces références étant toutefois indicées a̲ respectivement b̲ relativement à chacun des circuits résonateurs A et B.

Ainsi, chaque circuit résonateur comprend un premier et un deuxième ressort Sa1 Sa2 respectivement Sb1 Sb2 assurant chacun une liaison élastique et un jeu de cales de butée Ba1, B'a1 respectivement Bb1, B'b1. Ces dernières permettent d'assurer le maintien en position de fonctionnement de l'autre élément OE$_a$ respectivement OE$_b$ constituant l'électrode de signal de chaque circuit résonateur.

En ce qui concerne les circuits d'application de la différence de potentiel ceux-ci sont représentés sur la figure 3 de manière schématique par de simples lignes d'alimentation et peuvent être constitués par des micro-connexions permettant d'appliquer une tension positive respectivement négative sur les éléments d'ancrage RFa, RFb respectivement sur les électrodes fixes FEa respectivement FEb.

Le résonateur tel que représenté en figure 3 a été mis en oeuvre à partir de deux circuits résonateurs sensiblement identiques du type poutre encastrée en mode de vibration latérale et présentaient les dimensions suivantes: longueur 40 $\mu$m, largeur 3$\mu$m, épaisseur 15$\mu$m, ces dimensions étant les dimensions de conception sans la prise en compte du phénomène de surgravure, lequel est sensiblement supprimé grâce à la mise en oeuvre du procédé objet de la présente invention.

Les résultats de mesure ci-après ont été obtenus avec un écartement de fonctionnement e̲ défini à la valeur de 0,2 $\mu$m pour l'un des résonateurs et de 0,4 $\mu$m pour l'autre résonateur. Les dimensions effectives des circuits résonateurs constitutifs des résonateurs sont données dans le tableau ci-après:

| Nom de paramètre | Valeur |
| --- | --- |
| Longueur des poutres de résonateur E, $\mu$m | 40 |
| Largeur des poutres de résonateur E, $\mu$m | 3 |
| Epaisseur des poutres, $\mu$m | 15 |

(suite)

| Nom de paramètre | Valeur |
|---|---|
| Distance initiale entre l'électrode de signal OE et le résonateur E *Dres* | 1,8/2,0* |
| Distance initiale entre l'électrode de signal OE et les butés B, *Dbut,* $\mu$m | 1,6 |
| Distance initiale entre l'électrode de signal OE et les électrodes de moteur, *Dmot,* $\mu$m | 3,1 |
| * 1,8 $\mu$m pour le résonateur avec l'écartement conçu de 0,2 $\mu$m, 2,0 $\mu$m pour le résonateur avec l'écartement conçu de 0,4 $\mu$m. | |

On indique que pour le résonateur présentant un écartement de fonctionnement de 0,2 $\mu$m, l'écartement résiduel était de 1,8 $\mu$m alors que pour l'autre résonateur, le même écartement résiduel était de 2 $\mu$m pour un écartement de fonctionnement de 0,4 $\mu$m.

Le réglage de l'écart de fonctionnement e pour l'un et l'autre des résonateurs s'est avéré particulièrement fiable pour chacun des résonateurs précités. La tension nécessaire pour assurer le rapprochement des électrodes de signal était de 30 volts au maximum.

Après l'opération de rapprochement, c'est-à-dire le déplacement de l'électrode de signal formée par l'autre élément OE$_a$ respectivement OE$_b$, ces dernières restent en appui contre les cales de butée et pour revenir à l'état de repos la tension continue appliquée doit être baissée jusqu'à 20 volts.

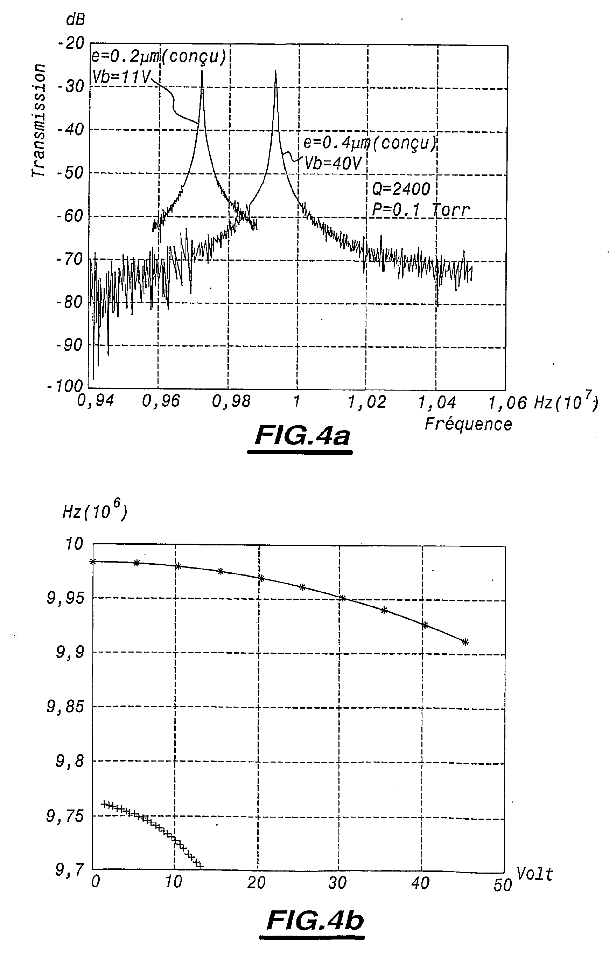

Les figures 4a et 4b permettent de représenter certains résultats expérimentaux relatifs au résonateur mis en oeuvre conformément à la figure 3 pour chaque résonateur.

La figure 4a représente la caractéristique de transmission de chaque résonateur, en fonction de la fréquence de l'excitation, à tension de polarisation de chaque circuit résonateur constante. L'axe des ordonnées est gradué en atténuation c'est-à-dire en dB et l'axe des abscisses en fréquence.

La figure 4b représente la caractéristique de l'évolution de la fréquence de résonance de chaque résonateur, l'axe des ordonnées étant gradué en fréquence et l'axe des abscisses en valeur de tension ou différence de potentiel appliquée.

La fréquence propre des circuits résonateurs et des résonateurs correspond à une polarisation sensiblement nulle. Cette fréquence propre est obtenue par extrapolation des courbes de la figure 4b. Une tension de polarisation ou différence de potentiel appliquée nulle provoquant des amplitudes trop faibles pour pouvoir être détectées. Alors qu'en théorie les fréquences propres des deux résonateurs devraient être sensiblement identiques, la différence entre celles-ci, de 2% environ, est imputable aux dispersions liées aux techniques de microfabrication.

Sur la figure 4b, la pente de la courbe correspondant au résonateur présentant l'écart de fonctionnement réduit à 0,2 $\mu$m est beaucoup plus raide que celle du résonateur dont l'écartement de fonctionnement n'est réduit qu'à 0,4 $\mu$m. Cet effet témoigne sans ambiguïté d'un meilleur coefficient de transduction pour le résonateur ayant le plus petit écartement de fonctionnement. En raison du fait que tous les autres paramètres de transduction des deux résonateurs sont identiques, on en déduit que l'écart résiduel est plus petit pour le résonateur conçu pour un écart de fonctionnement de 0,2 $\mu$m. De telles mesures permettent de certifier qualitativement les améliorations apportées par le procédé objet de la présente invention et les circuits résonateurs et résonateurs ainsi obtenus.

Enfin, des investigations ont montré que les valeurs réelles des écartements de fonctionnement telles que mentionnées dans le tableau précité sont alors proches des valeurs conçues au niveau de la conception des masques de fabrication. L'écartement de fonctionnement a ainsi pu être réduit de 3 $\mu$m à 0,2 $\mu$m ou 0,4 $\mu$m pour les résonateurs précités respectivement.

Relativement à la figure 4a on indique que les caractéristiques de transmission des deux résonateurs ont été établies pour des différences de potentiel appliquées constantes. Les différences de potentiel précitées ou tensions de polarisation ont été choisies pour obtenir des niveaux de transmission identiques à la fréquence de résonance de chaque résonateur. On constate en particulier que, pour la valeur de transmission maximale, atténuation minimale, les tensions de polarisation précitées sont dans un rapport sensiblement égal à 3,6. Le rapport précité permet de déterminer un facteur proche de la valeur 2 entre les écartements de fonctionnement des deux résonateurs qui correspondent aux valeurs de conception 0,2 et 0,4 $\mu$m.

Dans une situation comparable de mise en oeuvre de circuits résonateurs conformément aux techniques de l'art antérieur, c'est-à-dire en l'absence des améliorations que permet d'apporter le procédé objet de la présente invention, des caractéristiques comparables, pour un écartement résiduel de 3 $\mu$m, auraient nécessité une tension de polarisation, ou différence de potentiel appliquée proche de 2500 V, ce qui exclut une application industrielle effective des techniques de l'art antérieur.

On a ainsi décrit un procédé de réglage de l'écartement de deux éléments mécaniques d'une structure micromécanique sensiblement plane et un circuit résonateur et un résonateur correspondant particulièrement avantageux.

En particulier, l'architecture de moteur électrostatique mise en oeuvre permet d'obtenir des écartements de fonctionnement submicroniques, tout en utilisant des technologies standard de microgravure de silicium avec une seule couche structurelle, la couche structurelle de poly-silicium étant rapportée sur un matériau diélectrique par exemple.

Alors que les grandes difficultés de mettre en oeuvre des écartements suffisamment petits constituent un obstacle principal à l'utilisation des technologies de microgravure standard pour la fabrication des filtres microélectromécaniques ou d'actionneurs sous très faible tension, le procédé objet de la présente invention permet de s'affranchir totalement d'un tel obstacle, alors qu'aucune modification des processus de microgravure n'est nécessaire.

On indique en outre que, bien que la mise en oeuvre d'électrodes mobiles, en particulier de l'électrode de signal, exige une source de polarisation électrique supplémentaire, une telle exigence ne représente en aucun cas une contrainte importante, car la tension continue de 30 V, en l'absence de courant consommé, peut facilement être engendrée, même dans les systèmes portables.

Enfin, alors que dans le mode de réalisation décrit, une seule électrode FE est représentée, la mise en place de plusieurs électrodes peut être envisagée, lorsque la structure de l'élément E, constituant résonateur, est différente de celle d'une lame.

**Revendications**

1.  Procédé de réglage de l'écartement de fonctionnement de deux éléments mécaniques d'une structure mécanique sensiblement plane obtenue par un processus de microgravure, lesdits éléments mécaniques étant formés par un élément respectivement par un autre élément comprenant chacun une face sensiblement plane en vis-à-vis et présentant un écartement résiduel (Dres) sensiblement égal à la résolution dudit processus de microgravure, ledit procédé consistant au moins à attribuer à l'un desdits éléments (E) une position fixe de référence dans ladite structure:

    - à rendre libre, selon au moins un degré de liberté, dans la direction dudit écartement résiduel, ledit autre élément (OE) par rapport audit élément ;
    - à relier ledit autre élément à ladite position fixe de référence par une liaison élastique (S), ledit autre élément en présence de ladite liaison élastique occupant une position de repos pour laquelle l'écartement entre chaque face sensiblement plane en vis-à-vis est sensiblement égal audit écartement résiduel;
    **caractérisé en ce qu'**il consiste en outre :
    - à installer, entre ledit élément constituant ladite position fixe de référence dans ladite structure et ledit autre élément rendu libre, au moins une cale de butée (B) de façon à ménager entre ledit autre élément et ladite au moins une cale de butée un écartement de butée, de valeur déterminée, définissant l'amplitude maximale de déplacement dudit autre élément entre ladite position de repos et une position de butée constituant position de fonctionnement ;
    - à soumettre ledit autre élément à un déplacement antagoniste à ladite liaison élastique, jusqu'à ladite position de butée constituant position de fonctionnement, ce qui permet de réduire ledit écartement résiduel à un écartement de fonctionnement (e) égal à la différence entre cet écartement résiduel et ledit écartement de butée et inférieur à la résolution dudit processus de microgravure.

2.  Procédé selon la revendication 1, **caractérisé en ce que** ledit élément (E) et ledit autre élément (OE) étant constitués en un matériau électriquement conducteur, ladite étape consistant à soumettre ledit autre élément à un déplacement antagoniste à ladite liaison élastique (S) consiste à appliquer entre ledit autre élément et une électrode fixe liée audit élément une différence de potentiel électrique, l'ensemble formé par l'électrode fixe liée audit élément, ledit autre élément, ladite au moins une liaison élastique et ladite différence de potentiel électrique appliquée constituant un moteur électrostatique à entrefer ajustable.

3.  Procédé selon la revendication 2, **caractérisé en ce que** ladite structure constituant la structure d'un résonateur électromécanique, ledit élément (E) constituant élément résonateur, ledit autre élément (OE) constituant une électrode de signal et ladite liaison élastique (S) sont formés par des structures électriquement conductrices sensiblement planes, sur un substrat diélectrique, la fréquence de résonance mécanique dudit élément représente la fréquence de fonctionnement du signal dudit résonateur en mode de vibration latérale.

4.  Circuit résonateur électromécanique à entrefer latéral ajustable, comprenant au moins, formés par un processus de microgravure sur un substrat diélectrique et agencés selon une structure sensiblement plane un élément résonateur (E) électriquement conducteur ancré dans une structure présentant une position fixe de référence;

    - un autre élément (OE), constituant électrode de signal, l'élément résonateur et l'autre élément présentant chacun une face sensiblement plane en vis-à-vis séparées par un écartement résiduel (Dres) sensiblement égal à la résolution du processus de microgravure, ledit autre élément présentant un degré de liberté dans la direction dudit écartement résiduel;

- un élément d'ancrage (RF) dudit autre élément constituant électrode de signal ;

- au moins une liaison élastique (S) reliant ledit autre élément constituant électrode de signal et ledit élément d'ancrage dudit autre élément constituant électrode de signal, ledit autre élément constituant électrode de signal en présence de ladite au moins une liaison élastique occupant une position de repos pour laquelle l'écartement entre chaque face sensiblement plane en vis-à-vis est sensiblement égal audit écartement résiduel ;

**caractérisé en ce qu'**il comprend en outre:

- au moins une cale de butée (B) installée entre ladite structure présentant une position de référence et ledit autre élément, constituant électrode de signal, de façon à ménager entre ledit autre élément et ladite au moins une cale de butée un écartement de butée (e), de valeur déterminée, définissant l'amplitude maximale de déplacement dudit autre élément entre ladite position de repos et une position de butée, constituant position de fonctionnement ;

- des moyens l'application (RF, FE), entre ledit autre élément constituant électrode de signal et une électrode fixe vis-à-vis dudit élément constituant résonateur, d'une différence de potentiel électrique, l'ensemble formé par ledit élément résonateur, ledit autre élément constituant électrode de signal, ladite au moins une liaison élastique et lesdits moyens d'application d'une différence de potentiel électrique constituant un moteur électrostatique à entrefer ajustable en fonction de la différence de potentiel appliquée, ce qui permet de réduire ledit écartement résiduel à un écartement de fonctionnement égal à la différence entre cet écartement résiduel et ledit écartement de butée et inférieur à la résolution dudit processus de microgravure.

5. Circuit résonateur selon la revendication 4, **caractérisé en ce que** la fréquence de résonance mécanique dudit élément représente la fréquence de fonctionnement du signal dudit circuit résonateur en mode de vibration latérale.

6. Circuit résonateur selon l'une des revendications 4 ou 5, **caractérisé en ce que** celui-ci présente une structure sensiblement symétrique par rapport à un axe longitudinal de symétrie (X'X) sensiblement parallèle à la direction dudit écartement résiduel (Dres).

7. Circuit résonateur selon la revendication 6, **caractérisé en ce que** celui-ci comporte placés symétriquement par rapport audit axe longitudinal de symétrie :

- un premier (Sa1, Sb1) et un deuxième (Sa2, Sb2) ressort assurant chacun une liaison élastique;
- un jeu de deux cales de butée (Ba1, B'a1; Bb1, B'b1) permettant d'assurer le maintien en position de fonctionnement ledit autre élément (OEa, OEb) constituant électrode de signal.

8. Résonateur électromécanique à entrefer latéral, **caractérisé en ce qu'**il comporte :

- un premier circuit résonateur (A) selon l'une des revendications à 4 à 7, et, placé symétriquement en vis-à-vis dudit premier circuit résonateur,
- un deuxième circuit résonateur (B) selon l'une des revendications 4 à 7 disposé en tête bêche par rapport au premier circuit résonateur.

**Claims**

1. Method for adjusting the operating gap of two mechanical elements of a substantially planar mechanical structure obtained by a micro-etching process, the mechanical elements being formed by an element and by another element, respectively, each comprising a substantially planar face, those faces being arranged opposite each other, and having a residual gap (Dres) substantially equal to the resolution of the micro-etching process, the method consisting at least in assigning to one of the elements (E) a fixed reference position in the structure:

- rendering said other element (OE)free relative to said element, according to at least one degree of freedom in the direction of the residual gap;
- connecting the other element to the fixed reference position by a resilient link (S), the other element, in the presence of the resilient link, occupying a resting position for which the gap between each substantially planar face, which faces are arranged opposite each other, is substantially equal to the residual gap;
**characterised in that** it also consists in:

- installing, between the element constituting the fixed reference position in the structure and the other element, rendered free, at least one stop block (B), in order to provide between the other element and the at least one stop block an abutment gap, of predetermined value, defining the maximum amplitude of displacement of the other element between the resting position and an abutment position constituting the operating position;

- subjecting the other element to a displacement antagonistic to the resilient link as far as the abutment position constituting the operating position, which enables the residual gap to be reduced to an operating gap (e) equal to the difference between the residual gap and the abutment gap and smaller than the resolution of the micro-etching process.

2. Method according to claim 1, **characterised in that**, the element (E) and the other element (OE) being constituted by an electrically conductive material, the step consisting in subjecting the other element to a displacement antagonistic to the resilient link (S) consists in applying a difference in electrical potential between the other element and a fixed electrode connected to the element, the assembly formed by the fixed electrode connected to the element, the other element, the at least one resilient link and the applied difference in electrical potential constituting an electrostatic motor having an adjustable air-gap.

3. Method according to claim 2, **characterised in that** the structure constituting the structure of an electromechanical resonator, the element (E) constituting the resonator element, the other element (OE) constituting a signal electrode and the resilient link (S) are formed by substantially planar electrically conductive structures, on a dielectric substrate, the mechanical resonance frequency of the element represents the operating frequency of the signal of the resonator in lateral vibration mode.

4. Electromechanical resonator circuit having an adjustable lateral air-gap, comprising at least, formed by a micro-etching process on a dielectric substrate and arranged in accordance with a substantially planar structure, one electrically conductive resonator element (E) anchored in a structure having a fixed reference position;

- another element (OE), constituting the signal electrode, the resonator element and the other element each having a substantially planar face, which faces are arranged opposite each other and are separated by a residual gap (Dres) substantially equal to the resolution of the micro-etching process, the other element having a degree of freedom in the direction of the residual gap;

- an element (RF)for anchoring the other element constituting the signal electrode;

at least one resilient link (S) connecting the other element constituting the signal electrode and the element for anchoring the other element constituting the signal electrode, the other element constituting the signal electrode, in the presence of the at least one resilient link, occupying a resting position for which the gap between each substantially planar face, which faces are arranged opposite each other, is substantially equal to the residual gap; **characterised in that** it also comprises:

- at least one stop block (B) installed between the structure having a reference position and the other element, constituting the signal electrode, in order to provide between the other element and the at least one stop block an abutment gap (e), of predetermined value, defining the maximum displacement amplitude of the other element between the resting position and an abutment position, constituting the operating position;

- means (RF,FE)for applying a difference in electrical potential between the other element constituting the signal electrode and an electrode which is fixed relative to the element constituting the resonator, the assembly formed by the resonator element, the other element constituting the signal electrode, the at least one resilient link and the means for applying a difference in electrical potential constituting an electrostatic motor having an adjustable air-gap as a function of the applied difference in potential, which enables the residual gap to be reduced to an operating gap equal to the difference between that residual gap and the abutment gap and smaller than the resolution of the micro-etching process.

5. Resonator circuit according to claim 4, **characterised in that** the mechanical resonance frequency of the element represents the operating frequency of the signal of the resonator circuit in lateral vibration mode.

6. Resonator circuit according to either claim 4 or claim 5, **characterised in that** it has a structure that is substantially symmetrical relative to a longitudinal axis (X'X)of symmetry substantially parallel with the direction of the residual gap (Dres).

7. Resonator circuit according to claim 6, **characterised in that** it comprises, placed symmetrically relative to the longitudinal axis of symmetry:

- a first (Sa1, Sb1) and a second spring (Sa2,Sb2)each providing a resilient link;
- a set of two stop blocks (Ba1,B'a1;Bb1,B'b1) enabling the other element (OEa, OEb) constituting the signal electrode to be maintained in the operating position.

8. Electromechanical resonator having a lateral air-gap, **characterised in that** it comprises:

- a first resonator circuit (A) according to any one of claims 4 to 7 and, placed symmetrically opposite the first resonator circuit,
- a second resonator circuit (B) according to any one of claims 4 to 7, arranged head to tail relative to the first resonator circuit.

**Patentansprüche**

1. Verfahren zur Abstimmung bzw. Einstellung des Betriebsabstands zweier mechanischer Elemente einer durch ein Mikroätzverfahren hergestellten, im Wesentlichen planen mechanischen Struktur, wobei die genannten mechanischen Elemente durch ein Element beziehungsweise ein anderes Element gebildet werden, von denen jedes eine im Wesentlichen plane Seite umfasst, sich gegenüberstehend und einen Restabstand (Dres) aufweisend, der im Wesentlichen der Auflösung des genannten Mikroätzverfahrens entspricht,
wobei das genannte Verfahren wenigstens darin besteht:

dem einen der genannten Elemente (E) eine feste Bezugsposition in der genannten Struktur zuzuordnen;

- das genannte andere Element (OE) in Bezug auf das genannte Element gemäß wenigstens eines Freiheitsgrades in der Richtung des genannten Restabstands frei zu machen;
- das genannte andere Element mit der festen Bezugsposition durch eine elastische Verbindung (S) zu verbinden, wobei das andere Element in Präsenz der genannten elastischen Verbindung eine Ruheposition einnimmt, für die der Abstand zwischen den sich gegenüberstehenden planen Seiten im Wesentlichen gleich dem genannten Restabstand ist;

**dadurch gekennzeichnet, dass** es außerdem darin besteht:

- wenigstens einen Anschlag (B) einzurichten, zwischen dem in der genannten Struktur die genannte feste Bezugsposition bildenden genannten Element und dem genannten freigemachten anderen Element, um zwischen dem genannten anderen Element und dem genannten wenigstens einen Anschlag einen Anschlagsabstand von bestimmtem Wert zu schaffen, der die maximale Verschiebungsamplitude des genannten anderen Elements zwischen der genannten Ruheposition und einer die Betriebsposition bildenden Anschlagsposition definiert;
- das genannte andere Element einer zu der elastischen Verbindung antagonistischen Verschiebung bis zu der genannten die Betriebsposition bildenden Anschlagsposition zu unterwerfen, was ermöglicht, den genannten Restabstand zu reduzieren bis auf einen Betriebsabstand (e) gleich der Differenz zwischen diesem Restabstand und dem genannten Anschlagsabstand und kleiner als die Auflösung des genannten Mikroätzverfahrens.

2. Verfahren nach Anspruch 1, **dadurch gekennzeichnet, dass** das genannte Element (E) und das genannte andere Element (OE) durch ein elektrisch leitfähiges Material gebildet werden, wobei der darin bestehende Schritt, die genannte elastische Verbindung (S) einer antagonistischen Verschiebung zu unterwerfen, darin besteht, zwischen dem genannten anderen Element und einer mit dem genannten Element verbundenen festen Elektrode eine elektrisches Potential- bzw. Spannungsdifferenz anzulegen, wobei das Ganze, gebildet durch die mit dem genannten anderen Element verbundene feste Elektrode, das genannte andere Element, die genannte wenigstens eine elastische Verbindung und die genannte angelegte elektrische Potential- bzw. Spannungsdifferenz, einen elektrostatischen Motor mit justierbarem Luftspalt bildet.

3. Verfahren nach Anspruch 2, **dadurch gekennzeichnet, dass** die einen elektromechanischen Resonator bildende genannte Struktur, das das genannte Resonatorelement bildende Element (E), das die Signalelektrode bildende andere Element (OE) und die elastische Verbindung (S) durch im Wesentlichen plane elektrisch leitfähige Strukturen auf einem dielektrischen Substrat ausgebildet werden, wobei die mechanische Resonanzfrequenz des genannten Elements die Betriebsfrequenz des Signals des genannten Resonators im Lateralschwindungsmodus darstellt.

4. Elektromechanischer Resonatorkreis mit justierbarem seitlichem Luftspalt, ausgebildet durch ein Mikroätzverfahren auf einem dielektrischen Substrat und angeordnet gemäß einer im Wesentlichen planen Struktur, umfassend:

wenigstens ein elektrisch leitfähiges Resonatorelement (E), verankert in einer Struktur mit einer festen Bezugsposition;

- ein die Signalelektrode bildendes anderes Element (OE), wobei das Resonatorelement und das andere Element jeweils eine im Wesentlichen plane Seite aufweisen, sich gegenüberstehend und getrennt durch einen Restabstand (Dres) im Wesentlichen gleich der Auflösung des genannten Mikroätzverfahrens, wobei das andere Element in der Richtung des genannten Restabstands einen Freiheitsgrad aufweist;
- ein Verankerungselement (RF) des die Signalelektrode bildenden anderen Elements;
- wenigstens eine elastische Verbindung (S), die das die Signalelektrode bildende andere Element und das genannte Verankerungselement des die Signalelektrode bildenden anderen Elements verbindet, wobei das die Signalelektrode bildende andere Element in Präsenz der genannten wenigstens einen elastischen Verbindung eine Ruheposition einnimmt, für die der Abstand zwischen den sich gegenüberstehenden planen Seiten im Wesentlichen gleich dem genannten Restabstand ist;

**dadurch gekennzeichnet, dass** er außerdem umfasst:

- wenigstens einen Anschlag (B), eingerichtet zwischen der eine Bezugsposition aufweisenden genannten Struktur und dem genannten die Signalelektrode bildenden anderen Element, um zwischen dem genannten anderen Element und dem genannten wenigstens einen Anschlag einen Anschlagsabstand (e) von bestimmtem Wert zu schaffen, der die maximale Verschiebungsamplitude des genannten anderen Elements zwischen der genannten Ruheposition und der die Betriebsposition bildenden Anschlagsposition definiert;
- Einrichtungen (RF, FE) zum Anlegen einer elektrischen Potential- bzw. Spannungsdifferenz zwischen dem die Signalelektrode bildenden anderen Element und einer dem genannten Resonatorelement gegenüberstehenden festen Elektrode, wobei das Ganze, gebildet durch das genannte Resonatorelement, das die Signalelektrode bildende andere Element, die wenigstens eine elastische Verbindung und die genannten Einrichtungen zum Anlegen einer Potential- bzw. Spannungsdifferenz, einen elektrostatischen Motor mit in Abhängigkeit von der angelegten Potential- bzw. Spannungsdifferenz justierbarem Luftspalt bildet, was ermöglicht, den genannten Restabstand zu reduzieren bis auf einen Betriebsabstand gleich der Differenz zwischen diesem Restabstand und dem genannten Anschlagsabstand und kleiner als die Auflösung des genannten Mikroätzverfahrens.

5. Resonatorkreis nach Anspruch 4, **dadurch gekennzeichnet, dass** die mechanische Resonanzfrequenz des genannten Elements die Betriebsfrequenz des Signals des genannten Resonatorkreises im Lateralschwingungsmodus darstellt.

6. Resonatorkreis nach einem der Ansprüche 4 oder 5, **dadurch gekennzeichnet, dass** dieser eine in Bezug auf eine zu der Richtung des Restabstands (Dres) im Wesentlichen parallelen Längssymmetrieachse (x'x) im Wesentlichen symmetrische Struktur aufweist.

7. Resonatorkreis nach Anspruch 6, **dadurch gekennzeichnet, dass** dieser in symmetrischer Anordnung, bezogen auf die Längssymmetrieachse, umfasst:

- eine erste (Sa1, Sb1) und eine zweite (Sa2, Ab2) Feder, von denen jede eine elastische Verbindung gewährleistet;
- einen Satz von zwei Anschlägen (Ba1, B'a1; Bb1, B'b1), die ermöglichen, das die Signalelektrode bildende andere Element (OEa, OEb) in der Betriebsposition zu halten.

8. Elektromechanischer Resonator mit seitlichem Luftspalt, **dadurch gekennzeichnet, dass** er umfasst:

- einen ersten Resonatorkreis (A) nach einem der Ansprüche 4 bis 7, und gegenüber, symmetrisch zum ersten Resonatorkreis,
- einen zweiten Resonatorkreis (B) nach einem der Ansprüche 4 bis 7, entgegengesetzt angeordnet in Bezug auf den ersten Resonator.

Elément E
Autre Elément OE
Dres

E fixe(RF) — A

OE libre selon Dres — B

Liaison élastique OE_RF — C

Installation butée B
Dbut — D

Déplacement OE sur B — DE

e=Dres-Dbut

## FIG.1

**FIG.2a**

**FIG.2b**

**FIG.3**

**FIG.4a**

**FIG.4b**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **Kun Wang ; Yinglei Yu ; Ark-Chew Woung ; Clara T.-C. Nguyen.** VHF Free-Free Beam High-Q Micro-mechanical Resonators. *Technical Digest, 12th International IEEE Micro Electro Mechanical Systems Conference,* 17 Janvier 1999, 453-458

- **T. Hirano ; T. Furuhata ; K.J. Gabriel ; H. Fujita.** Operation of sub-micron gap electrostatic comb-drive actuators. *International Conference on Solid-State Sensors and Actuators,* 24 Juin 1991, 873-876